Europäisches Patentamt

European Patent Office

Office européen des brevets

(11) Veröffentlichungsnummer: **0 283 771**
**A1**

(12) **EUROPÄISCHE PATENTANMELDUNG**

(21) Anmeldenummer: 88103098.5

(22) Anmeldetag: 02.03.88

(51) Int. Cl.4: **C23C 18/22**

(30) Priorität: **12.03.87 DE 3708214**

(43) Veröffentlichungstag der Anmeldung:
**28.09.88 Patentblatt 88/39**

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Mahlkow, Hartmut**
**Handjerystrasse 85**
**D-1000 Berlin 41(DE)**
Erfinder: **Römer, Michael, Dr.**
**Topitzweg 7**
**D-1000 Berlin 13(DE)**
Erfinder: **Rosskamp, Günther, Dr.**
**Querstrasse 10**
**D-1000 Berlin 37(DE)**
Erfinder: **Seidenspinner, Hubert-Matthias, Dr.**
**Mescheder Weg 36**
**D-1000 Berlin 27(DE)**
Erfinder: **Stein, Ludwig**
**Querstrasse 5**
**D-1000 Berlin 37(DE)**
Erfinder: **Strache, Waltraud**
**Lübener Weg 35**
**D-1000 Berlin 51(DE)**

(54) Verfahren zur haftfesten Metallisierung von Kunststoffen.

(57) Die Erfindung betrifft ein Verfahren zur haftfesten Metallisierung von Kunststoffen durch Vorbehandlung der Kunststoffe und anschließende Aktivierung sowie chemische und gegebenenfalls galvanische Metallabscheidung, dadurch gekennzeichnet, daß die Kunststoffe zunächst mit einer alkalischen Lösung von Oxidationsmitteln und darauf mit einer Metallsalzlösung vorbehandelt werden.

EP 0 283 771 A1

## VERFAHREN ZUR HAFTFESTEN METALLISIERUNG VON KUNSTSTOFFEN

Die Erfindung betrifft ein Verfahren zur haftfesten Metallisierung von Kunststoffen durch Vorbehandlung der Kunststoffe und abschließende Aktivierung sowie chemische und gegebenenfalls galvanische Metallabscheidung.

Die Metallisierung von Kunststoffen ist bereits bekannt. Sie erfolgt üblicherweise durch Aktivierung der Oberfläche und nachfolgende chemische sowie galvanische Metallabscheidung.

Voraussetzung hierfür ist eine Vorbehandlung der Kunststoffoberfläche, die in der Regel durch Einwirkung saurer oder alkalischer Ätzmedien erfolgt, von denen zum Beispiel alkalische Kaliumpermanganatlösungen zu nennen sind.

Es hat sich jedoch gezeigt, daß chemisch sehr stabile Kunststoffe, wie zum Beispiel Polyetherimide und Polyimide, gegenüber diesen Ätzmedien resist sind, was außerordentlich nachteilig ist, da ein großes Bedürfnis besteht, auch Kunststoffe dieser Art haftfest zu metallisieren.

Die vorliegende Erfindung hat die Aufgabe, ein Verfahren der eingangs genannten Art zu schaffen, welches eine haftfeste Metallisierung von chemisch sehr stabilen Kunststoffen ermöglicht.

Diese Aufgabe wird durch ein Verfahren gemäß dem Kennzeichen des Patentanspruchs gelöst.

Besondere Ausführungsformen sind in den Unteransprüchen gekennzeichnet.

Das erfindungsgemäße Verfahren eignet sich überraschenderweise zur Vorbehandlung und nachfolgende haftfeste Metallisierung von chemisch sehr stabilen Kunststoffen, wie insbesondere Polyetherimiden und Polyimiden.

Ein besonderer Vorteil des erfindungsgemäßen Verfahrens besteht darin, daß sich auf den vorbehandelten Kunststoffoberflächen keine Rückstände bilden, so daß deren Entfernung wie im Falle der mit alkalischen Ätzmedien arbeitenden bekannten Verfahren entfällt.

Ein weiterer technischer Vorteil besteht darin, daß die erfindungsgemäß behandelten Kunststoffoberflächen selbst mit Hilfe eines Rasterelektronenmikroskops keine Unterschiede gegenüber unbehandelten Oberflächen erkennen lassen, was darauf hindeutet, daß die Makrostruktur der Kunststoffoberfläche nicht verändert wird.

Die Haftwerte der erfindungsgemäß abgeschiedenen Metallschichten sind sogar nach einem Lötprozess von etwa 30 Sekunden Dauer bei 260° C hervorragend, was von außerordentlicher technischer Bedeutung ist.

Die Durchführung des erfindungsgemäßen Verfahrens erfolgt durch Behandeln der Kunststoffoberflächen mit der alkalischen Lösung des Oxidationsmittels, was durch Tauchen oder Beschwallen mittels einer Düseneinrichtung erfolgen kann, was insbeondere bei horizontal geführten Leiterplatten von Vorteil ist.

Vorteilhafterweise kann diese Beschwallung auch bei gleichzeitiger Einwirkung eines Ultraschalls durchgeführt werden.

Zweckmäßigerweise wird die Oberfläche anschließend mit Wasser gespült und dann mit der Metallsalzlösung in Kontakt gebracht.

Nach einem weiteren Spülvorgang wird die Oberfläche aktiviert, worauf chemisch sowie gegebenenfalls galvanisch Metall abgeschieden wird.

Als Metallsalze werden erfindungsgemäß Eisen-, Zinn-, Aluminium-und Zinksalze, wie zum Beispiel die Chloride oder Oxide, verwendet, und zwar in bevorzugten Konzentrationen von 0,01 bis 150 g/Liter. Ihre Anwendung erfolgt in wässriger Lösung, die gegebenenfalls sauer oder alkalisch sein kann, und der gewünschtenfalls auch geeignete Komplexbildner zugesetzt werden können.

Diese Salze lassen sich sowohl jeweils allein oder in Form ihrer Mischungen anwenden. Als vorteilhaft für eine Steigerung der Haftfestigkeit hat es sich erwiesen, wenn das Substrat nach erfolgter Metallsalzbehandlung mit einer Fixierlösung oder mit einer Alkalihydroxid-Lösung behandelt wird.

Geeignete Oxidationsmittel sind beispielsweise Jod, Brom, Chlor, Bromate, Chlorate, Peroxidsulfate, Peroxide, Permanganate oder deren Mischungen, die in alkalischer Lösung in einer bevorzugten Konzentration von 0,1 bis 500 g/Liter angewandt werden.

Die alkalische Lösung dieser Oxidationsmittel enthält als Alkalihydroxid zum Beispiel Natriumhydroxid, Kaliumhydroxid, Lithiumhydroxid oder deren Mischungen in einer bevorzugten Konzentration von 0,1 bis 200 g/Liter.

Die Aktivierung der erfindungsgemäßen vorbehandelten Kunststoffoberflächen kann mittels üblicher Aktivierungslösungen in üblicher Weise erfolgen. Besonders geeignet sind Aktivierungslösungen , welche Palladium-oder Silberionen enthalten, die mit geeigneten Reduktionsmitteln zum nullwertigen Metall reduziert werden.

Zur chemischen Metallisierung lassen sich schließlich übliche stromlos arbeitende Bäder auf Basis von Kupfer oder Nickel verwenden.

Die erfindungsgemäße Vorbehandlung erfolgt zweckmäßigerweise bei Temperaturen von 20 bis 30° C.

Die erfindungsgemäß metallisierten Kunststoffe finden insbesondere Verwendung in der Elektroindustrie, zum Beispiel für Formteile, vorzugsweise als Leiterplatten in der Elektronik.

Die folgenden Beispiele dienen zur Erläuterung der Erfindung.

## BEISPIEL 1

Eine Polyimidfolie wird in eine wässrige Lösung von 40 g/Liter Kaliumpermanganat und 30 g/Liter Kaliumhydroxid getaucht. Nach 5 Minuten wird die Folie entnommen, mit Wasser gespült und für 5 Minuten in eine Lösung von 10 g/Liter Eisen-(III)-chlorid und 48 g/Liter Trikaliumcitrat gebracht, gespült und in einer Natriumhydroxidlösung mit einem pH-Wert von 10 1 Minute lang nachbehandelt.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 15 N/cm (Kohäsionsbruch in der Folie) vor dem Löten und 6-14 N/cm nach dem Löten.

## BEISPIEL 2

Eine Polyimidfolie wird in eine wässrige Lösung von 40 g/Liter Kaliumpermanganat und 30 g/Liter Kaliumhydroxid getaucht. Nach 5 Minutren wird die Folie entnommen, mit Wasser gespült und für 5 Minuten in eine Lösung von 1,5 g/Liter Zinn-(II)-chlorid, 5 g/Liter Glycin und 25 g/Liter Natriumhydroxid gebracht.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 11 N/cm vor dem Löten und 6-10 N/cm nach dem Löten.

## BEISPIEL 3

Eine Polyimidfolie wird in eine wässrige Lösung von 20 g/Liter Kaliumpermanganat und 100 g/Liter Natriumhydroxid getaucht. Nach 5 Minuten wird die Folie entnommen, mit Wasser gespült und für 5 Minuten in eine Lösung von 10 g/Liter Zinkoxid, 20 g/Liter Glycin und 100 g/Liter Natriumhydroxid gebracht.

Anschließend wird die Folie gespült, in einem Palladiumaktivator aktiviert und die Palladiumionen dann in einem Reduktionsbad zu Palladiummetall redziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 15 N/cm vor dem Löten und 10 - 15 N/cm - Kohäsionsbruch in der Folie - nach dem Löten.

## BEISPIEL 4

Eine Polyimidfolie wird in eine wässrige Lösung von 20 g/Liter Kaliumpermanganat und 100 g/Liter Natriumhydroxid getaucht. Nach 5 Minuten wird die Folie entnommen, mit Wasser gespült und für 5 Minuten in eine Lösung von 30 g/Liter Aluminiumsulfat gebracht, gespült und in einer Natriumhydroxidlösung mit einem pH-Wert von 10 eine Minute lang nachbehandelt.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr.2.4.9 beträgt 10 - 14 N/cm vor dem Löten und 6 - 12 N/cm nach dem Löten.

## BEISPIEL 5

Eine Polyimidfolie wird in eine wässrige Lösung von 5 g/Liter Jod und 30 g/Liter Natriumhydroxid getaucht. Nach 5 Minuten Einwirkzeit wird die Folie entnommen, mit Wasser gespült und für 5 Minuten in eine Lösung von 10 g/Liter Eisen(III)-chlorid und 48 g/Liter Trikaliumcitrat gebracht, gespült und in einer Natriumhydroxidlösung mit einem pH-Wert von 10 1 Minute lang nachbehandelt. Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Fee Wheeling Nr. 2.4.9 beträgt 4-8 N/cm vor dem Löten und 4-8 N/cm nach dem Löten.

## BEISPIEL 6

Eine Polyimidfolie wird in eine wässrige Lösung von 5 g/Liter Brom und 20 g/Liter Natriumhydroxid getaucht. Nach 5 Minuten Einwirkzeit wird die Folie entnommen, mit Wasser gespült und für 5 Minuten in eine Lösung von 10 g/Liter Eisen(III)-chlorid und 48 g/Liter Trikaliumcitrat gebracht, gespült und in einer Natriumhydroxidlösung mit einem pH-Wert von 10 1 Minute lang nachbehandelt.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr.2.4.9 beträgt 4-8 N/cm vor dem Löten und 4-8 N/cm nach dem Löten.

## BEISPIEL 7

Eine Polyimidfolie wird in eine wässrige Lösung von Natriumhypochlorid mit 13 Prozent freiem Chlor getaucht. Nach 5 Minuten wird die Folie entnommen, mit Wasser gespült und für 5 Minuten in eine Lösung von 10 g/Liter Zinkoxid, 20 g/Liter Glycin und 100 g/Liter Natriumhydroxid gebracht.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr.2.4.9 beträgt 2-4 N/cm vor dem Löten und 2 N/cm nach dem Löten.

## BEISPIEL 8

Eine Polyimidfolie wird in eine wässrige Lösung von 100 g/Liter Kaliumchromat und 20 g/Liter Kaliumhydroxid getaucht. Nach 5 Minuten wird die Folie entnommen, mit Wasser gespült und für 5 Minuten in eine Lösung von 1,5 g/Liter Zinn-(II)-chlorid, 5 g/Liter Glycin und 25 g/Liter Natriumhydroxid gebracht.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 5-10 N/cm vor dem Löten und 2 N/cm nach dem Löten.

## BEISPIEL 9

Eine Polyimidfolie wird in eine wässrige Lösung von 100 g/Liter Kaliumperoxidisulfat und 20 g/Liter Natriumhydroxid getaucht. Nach 5 Minuten wird die Folie entnommen, mit Wasser gespült und für 5 Minuten in eine Lösung von 10 g/Liter Zinkoxid, 20 g/Liter Glycin und 100 g/Liter Natriumhydroxid gebracht.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 6-8 N/cm vor dem Löten und 2 N/cm nach dem Löten.

## BEISPIEL 10

Eine Polyimidfolie wird in eine wässrige Lösung von 20 g/Liter Kaliumbromat und 30 g/Liter Kaliumhydroxid getaucht. Nach 5 Minuten wird die Folie entnommen, mit Wasser gespült und für 5 Minuten in eine Lösung von 10 g/Liter Zinkoxid, 20 g/Liter Glycin und 100 g/Liter Natriumhydroxid gebracht.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 6 - 7 N/cm vor dem Löten und 2 N/cm nach dem Löten.

## BEISPIEL 11

Eine Polyimidfolie wird in eine wässrige Lösung von 40 g/Liter Kaliumpermanganat und 30 g/Liter Kaliumhydroxid für 5 Minuten getaucht.

Anschließend wird die Folie gespült, in einem Palladiumaktivator aktiviert und die Palladiumionen dann in einem Reduktionsbad zu Palladiummetall reduziert.

Nun erfolgt die chemisch reduktive Abscheidung einer dünnen Kupferschicht, die galvanisch mit Kupfer verstärkt wird.

Der Haftwert, gemessen nach IPC-FC-232A Free Wheeling Nr. 2.4.9 beträgt 1 - 2 N/cm vor dem Löten und 0,5 N/cm nach dem Löten.

BEISPIEL 12

Eine Polyetherimid-Platte (IPC-Norm) wird in eine Lösung von 30 g/Liter Kaliumpermanganat, 30 g/Liter Kaliumhydroxid sowie 0,5 g/Liter eines nicht durch KMnO₄ oxidierbaren Netzmittels bei 50° C getaucht. Nach 10 Minuten wird die Platte entnommen, mit Wasser gespült und 3 Minuten in eine 2,5 %ige Oxalsäurelösung getaucht.

Anschließend wird die Platte gespült, in einem Palladiumaktivator aktiviert und die Palladiumionen dann in einem Reduktionsbad zu Palladiummetall reduziert. Nachfolgend wird die so vorbehandelte Platte in einem chemisch reduktiven Kupferbad mit einer dünnen Kupferschicht metallisiert und galvanisch mit Kupfer auf 35 m Schichtdicke verstärkt.

Der Haftwert, gemessen nach IPC-FC 232A Free Wheeling Nr. 2.4.9, beträgt 4 - 5 N/cm vor dem Löten.

BEISPIEL 13

Eine Polyetherimid-Platte (IPC-Norm) wird wie im Beispiel 12 beschrieben, behandelt. Zusätzlich wird die Platte, nach der Behandlung mit 2,5 %iger Oxalsäurelösung und Spülen mit Wasser, 5 Minuten lang in einer metallsalzhaltigen Lösung von 10 g Eisen (III)-chlorid und 48 g Trikaliumcitrat (pH-Wert mit KOH (33 %ig auf 7,1 eingestellt) getaucht. Dann wird die Platte gespült mit einem Palladium aktiviert und darauf chemisch verkupfert.

Der Haftwert, gemessen nach IPCFC 232A Free Wheeling Nr. 2.4.9, beträgt 7 - 8 N/cm vor dem Löten.

BEISPIEL 14

Eine Polyetherimid-Platte wird wie im Beispiel 13 beschrieben, vorbehandelt, nach der Behandlung mit der metallsalzhaltigen Lösung wird die Platte zusätzlich mit einer 2 %igen Natriumhydroxidlösung 3 Minuten behandelt und danach aktiviert, reduziert und chemisch verkupfert.

Der Haftwert, gemessen nach IPCFC 232A Free Wheeling Nr. 2.4.9, läßt sich durch diese Behandlung auf 9 - 12 N/cm steigern.

Ansprüche

1. Verfahren zur haftfesten Metallisierung von Kunststoffen durch Vorbehandlung der Kunststoffe und anschließende Aktivierung sowie chemische und gegebenenfalls galvanische Metallabscheidung, dadurch gekennzeichnet, daß die Kunststoffe zunächst mit einer alkalischen Lösung von Oxidationsmitteln und darauf mit einer Metallsalzlösung vorbehandelt werden.

2. Verfahren gemäß Anspruch 1, dadurch gekennzeichnet, daß als Metallsalze Eisen-, Zinn-, Aluminium-, und/oder Zinksalze oder deren Mischungen verwendet werden.

3. Verfahren gemäß Anspruch 1, dadurch gekennzeichnet, daß die Metallsalzlösung eine wässrige Lösung darstellt.

4. Verfahren gemäß Ansprüchen 1 bis 3, dadurch gekennzeichnet, daß die Metallsalzlösung die Metallsalze in einer Konzentration von 0,01 - 150 g/Liter enthält.

5. Verfahren gemäß Anspruch 1, dadurch gekennzeichnet, daß als Oxidationsmittel Jod, Brom, Chlor, Bromate, Chromate, Peroxidisulfate, Peroxide und/oder Permanganate oder deren Mischungen verwendet werden.

6. Verfahren gemäß Ansprüchen 1 und 5, dadurch gekennzeichnet, daß die alkalische Lösung die Oxidationsmittel in einer Konzentration von 0,1 - 500 g / Liter Wasser enthält.

7. Verfahren gemäß Anspruch 1, dadurch gekennzeichnet, daß die alkalische Lösung als Alkalihydroxid Natriumhydroxid, Kaliumhydroxid, Lithiumhydroxid oder deren Mischungen in Konzentrationen von 0,1 - 200 g/Liter enthält.

8. Verfahren gemäß Anspruch 1, dadurch gekennzeichnet, daß Kunststoffe auf Basis von Polyimiden oder Polyetherimiden metallisiert werden.

9. Verfahren gemäß Anspruch 1, dadurch gekennzeichnet, daß die Behandlung mittels der alkalischen Lösung von Oxidationsmitteln unter Ultraschalleinwirkung durchgeführt wird.

10. Verfahren gemäß Anspruch 1, dadurch gekennzeichnet, daß die Kunststoffe nach der Vorbehandlung mittels einer Aktivierungslösung enthaltend Palladium-oder Silberionen aktiviert und darauf mit einem üblichen Reduktionsmittel behandelt werden, worauf unter Verwendung eines chemischen Metallbades vorzugsweise Kupfer, Nickel oder deren Legierungen abgeschieden werden.

11. Verfahren gemäß Ansprüchen 1 bis 10 zur Herstellung von metallischen Formteilen, vorzugsweise Leiterplatten zur Verwendung in der Elektronik.

12. Metallische Formteile, wie Leiterplatten, hergestellt nach Verfahren gemäß Ansprüchen 1 bis 10.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 515 829 (DECKERT) * Spalte 3, Zeilen 43-68; Spalte 4, Zeilen 1-55 * --- | 1-7,10, 11 | C 23 C 18/22 |
| X | DE-A-2 239 908 (AEG ISOLIER- UND KUNSTSTOFF GmbH) * Seite 4, Zeilen 21-28 * ----- | 1,2,3,5 ,10,11 | |

RECHERCHIERTE SACHGEBIETE (Int. Cl.4)

C 23 C
H 05 K
C 08 J

Der vorliegende Recherchenbericht wurde für alle Patentansprüche erstellt

| Recherchenort | Abschlußdatum der Recherche | Prüfer |
|---|---|---|
| DEN HAAG | 04-07-1988 | NGUYEN THE NGHIEP |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes Dokument

EPO FORM 1503 03.82 (P0403)